# EUROPÄISCHE PATENTANMELDUNG

(11) **EP 1 435 692 A1**
(43) Veröffentlichungstag der Anmeldung: **07.07.2004**
(21) Anmeldenummer: 02029065.6
(22) Anmeldetag: 30.12.2002
(51) Int. Cl.: H03K 17/96, G01R 27/26

(54) **Anordnung und Verfahren zum Detektieren einer Berührung eines Sensorelements**

(71) Anmelder: Infineon Technologies AG, 81669 München (DE)
(72) Erfinder: Treiber, Josef, 8380 Jennersdorf (AT)
(74) Vertreter: Epping Hermann & Fischer

(57) **Zusammenfassung**

Die Erfindung beschreibt eine Anordnung zum Detektieren einer Berührung eines Sensorelementes mit einer ersten Einrichtung (10)s, die ein von der Berührung unabhängiges erstes Signal erzeugt, und mit einer zweiten Einrichtung (20), die ein von der Berührung abhängiges zweites Signal erzeugt, sowie mit einer Auswerte-Einrichtung (30), die bei Abweichung zwischen dem ersten und dem zweiten Signal ein weiteres Signal (DETECT) abgibt. Die Erfindung arbeitet alternativ nach dem Prinzip der Signallaufzeitveränderung oder der Pulsmodulation.

## Beschreibung

### Technisches Gebiet

Die Erfindung betrifft eine Anordnung und ein Verfahren zum Detektieren einer Berührung eines Sensorelementes. Insbesondere soll die Berührung des Sensorelementes mit einem Finger oder einem Gegenstand, der ähnliche Materialeigenschaften wie ein Finger hat, erkannt werden.

### Stand der Technik

Zur Detektion einer Berührung eines Sensorelementes sind aus dem Stand der Technik verschiedene Vorschläge bekannt. Die einfachste Möglichkeit besteht darin, neben dem Sensorelement weitere Bauelemente, wie zum Beispiel eine Leuchtdiode, eine Schalter oder einen Widerstand vorzusehen, die die Annäherung oder Berührung eines Fingers oder eines ähnlichen Gegenstandes signalisieren.

Eine andere, komplexere Möglichkeit besteht darin, beim Aufsetzen des Fingers oder des Gegenstandes auf das Sensorelement das entstehende Bild mittels einer Bilderkennungssoftware auszuwerten. Die Auswertung erfolgt dabei unter Einsatz einer indirekten Messung. Das Sensorelement selbst wird somit durch optische Elemente auf Annäherung eines Fingers oder eines anderen Gegenstandes überwacht. Die beiden Verfahren weisen den Nachteil auf, dass neben dem Sensorelement zusätzliche, externe Bauelemente benötigt werden, die einer hohen Integrationsdichte entgegenstehen.

Die Berührung kann auch durch das Sensorelement selbst detektiert werden, indem das Bild eines Fingerabdruckes beim Auflegen auf das Sensorelement ausgewertet wird. Diese Lösung erfordert jedoch besondere Schaltungen zur Durchführung komplexer Rechenoperationen, um festzustellen, ob der Finger oder der Gegenstand das Sensorelement bereits berührt bzw. diesem angenähert ist.

Bei dieser Variante werden zwar keine zusätzlichen (externen) Bauelemente benötigt, dafür sind zusätzliche Schaltungselemente erforderlich. Die Berührungserkennung funktioniert darüber hinaus nur dann, wenn die Elektronik des Sensorelementes aktiv ist. Soll das Sensorelement mit der Funktionalität eines Stromsparmodus versehen werden, so hat dies zur Folge, dass weitere Schaltungselemente vorgesehen werden müssen, die einen Übergang vom Stromsparmodus zum Normalmodus ermöglichen, sobald ein Finger auf das Sensorelement gelegt wird.

### Darstellung der Erfindung

Die Aufgabe der vorliegenden Erfindung besteht deshalb darin, eine Anordnung und ein Verfahren zum Detektieren einer Berührung eines Sensorelementes anzugeben, die die oben genannten Nachteile nicht aufweist.

Diese Aufgaben werden durch eine Anordnung mit den Merkmalen des Anspruches 1 und durch die Verfahren mit den Merkmalen der Ansprüche 15 und 16 gelöst.

Vorteilhafte Ausgestaltungen ergeben sich aus den abhängigen Ansprüchen.

Das der Erfindung zugrunde liegende Prinzip besteht darin, bei der Berührung des Sensorelementes aufgrund einer sich ändernden Kapazität des Sensorelementes eine Änderung der Laufzeit des Signales herbeizuführen und anschließend einen Vergleich der veränderten Laufzeit mit der Laufzeit eines Referenzsignales vorzunehmen. Das Referenzsignal hat dabei eine Laufzeit, die dem Zustand entspricht, wenn auf dem Sensorelement kein Finger bzw. Gegenstand aufgelegt ist.

Ein alternatives Verfahren besteht darin, bei der Berührung des Sensorelementes aufgrund einer sich ändernden Kapazität des Sensorelementes eine Änderung der Pulsbreite eines Signals mit konstanter Frequenz herbeizuführen, und anschließend einen Pulsbreiten-Vergleich mit einem Referenzsignal gleicher Frequenz vorzunehmen. Auch hier gilt, dass das Referenzsignal eine Pulsbreite aufweist, die der Pulsbreite bei der Kapazität des Sensorelementes entspricht, wenn kein Finger bzw. Gegenstand auf demselben aufgelegt ist.

Der Vorteil der erfindungsgemäßen Verfahren besteht darin, dass höchst einfache Messprinzipien zur Anwendung kommen, die vollkommen unabhängig von den Messprinzipien sind, die zur ADU bei Sensorelementen (z.B. Fingerprint-Sensoren)verwendet werden. Insbesondere erlaubt das erfindungsgemäße Vorgehen eine separate Entwicklung und Optimierung der Berührungsmessung von den Messschaltungen und Messprinzipien des eigentlichen Sensorelementes. Dennoch werden nur wenig zusätzliche Bauelemente benötigt, die sich zudem zusammen mit dem Sensorelement in einer integrierten Schaltung herstellen lassen. Es lässt sich deshalb eine höhere Integration gegenüber externen Elementen, wie den Eingangs genannten Leuchtdioden, Schaltern oder Widerständen, realisieren.

Die erfindungsgemäße Anordnung zum Detektieren einer Berührung eines Sensorelementes umfaßt eine erste Einrichtung, die ein von der Berührung unabhängiges erstes Signal erzeugt und eine zweite Einrichtung, die ein von der Berührung abhängiges zweites Signal erzeugt, sowie eine Auswerte-Einrichtung, die bei Abweichung zwischen dem ersten und dem zweiten Signal ein weiteres Signal abgibt.

Eine Abweichung zwischen dem ersten und dem zweiten Signal ist vorzugsweise im Falle einer Berührung der zweiten Einrichtung gegeben. Im Umkehrschluss bedeutet dies, solange keine Berührung des Sensorelementes vorliegt, werden von der ersten und der zweiten Einrichtung Signale erzeugt, die identisch oder nahezu identisch sind.

In einer Ausgestaltung der Erfindung weist die zweite Einrichtung einen zweiten Ladungsspeicher auf, dessen Kapazität mit einer Berührung veränderbar ist. Vorzugsweise stellt der Ladungsspeicher das Sensorelement dar.

Die Erfindung nutzt somit die elektrischen Eigenschaften eines Sensorelementes aus. Das Sensorelement weist nämlich unterschiedliche elektrische Kapazitäten auf, abhängig davon, ob dieses von einem Finger bzw. Gegenstand berührt wird oder nicht.

In einer ersten Variante der Erfindung arbeiten die erste und die zweite Einrichtung nach dem Prinzip der Signallaufzeitveränderung. Die Größe der Kapazität des zweiten Ladungsspeichers verändert in einer elektrischen Schaltung (der ersten Einrichtung) die Laufzeit eines Digitalsignales, womit sich eine unterschiedliche Laufzeit dieses Signales im Falle einer Berührung oder Nicht-Berührung ergibt. Die Berührungserkennung erfolgt dabei durch den Vergleich dieser Laufzeit mit der Laufzeit eines Referenzsignales.

Die erste Einrichtung weist zu diesem Zweck deshalb einen ersten Ladungsspeicher auf, dessen Kapazität konstant ist. Unabhängig davon, ob auf dem Sensorelement ein Finger oder anderer Gegenstand aufgelegt wird oder nicht, wird die Laufzeit eines Digitalsignales durch diesen ersten Ladungsspeichers nicht beeinflußt. Der erste Ladungsspeicher liegt deshalb im Signalpfad des Referenzsignales.

Vorzugsweise weisen die erste und die zweite Einrichtung jeweils einen Komparator auf, der die an den ersten und dem zweiten Ladungsspeicher anliegende Spannung jeweils mit einer Referenzspannung vergleicht. An den Ausgängen der Komparatoren läßt sich somit ein eindeutiges Signal abgreifen, welches Aufschluss über die Ladung und damit über die an den jeweiligen Ladungsspeicher anliegende Spannung gibt. Die von den Komparatoren erzeugten Ausgangssignale werden der Auswerte-Einrichtung für die weitere Auswertung zugeführt. Die Auswerte-Einrichtung verfügt zu diesem Zweck über Schaltungselemente, die die Ausgangssignale beider Komparatoren miteinander vergleicht und somit eine Abweichung oder Übereinstimmung der Laufzeit der Signale feststellt.

In einer Ausgestaltung der Erfindung weisen die erste und die zweite Einrichtung jeweils eine Stromquelle und einen zwischen der Stromquelle und dem jeweiligen Ladungsspeicher gelegenen Schalter auf, wobei die Schalter in Abhängigkeit eines Taktsignalgenerators den jeweiligen Ladungsspeicher mit der Stromquelle oder einem Bezugspotential verbinden. Solange die Stromquellen über dem Schalter mit dem jeweiligen Ladungsspeicher verbunden sind, erhöht sich die Ladung des Ladungsspeichers. Dadurch bedingt ergibt sich ein Anstieg der über dem Ladungsspeicher anliegenden Spannung, welche einem Eingang des Komparators zugeführt wird. Abhängig davon, ob ein Finger bzw. Gegenstand auf dem Sensorelement (= Ladungsspeicher) liegt oder nicht, wird die Spannung schneller oder langsamer erreicht als die Spannung an dem ersten Ladungsspeicher, dessen Kapazität konstant ist. Werden die Schalter durch den Taktsignalgenerator mit dem Bezugspotential verbunden, so werden die jeweiligen Ladungsspeicher entladen. Ein erneutes, d.h. getaktetes Verbinden der Ladungsspeicher mit den Stromquellen ermöglicht das wiederholte Feststellen, ob eine Berührung vorliegt oder nicht.

Diese Variante der Erfindung stellt eine von den Bauelementen des Sensorelements unabhängige Schaltung zur Berührungserkennung dar. Die Erfindung verwendet eine Relativmessung zur Berührungserkennung durch Kombination eines bei kapazitiven Sensoren vorhandenen Sensorelementes mit einem Referenzelement. Die Anordnung benötigt wesentlich weniger Strom als aus dem Stand der Technik bekannte Lösungen. Die Berührungserkennung kann vollständig autonom vom Sensorelement betrieben werden. Insbesondere ist die Berührungserkennung auch dann möglich, wenn die übrigen Komponenten des Sensorelementes abgeschaltet sind. Bei eingeschalteten Sensorelement (z.B. zur Erfassung des biometrischen Abdrucks eines Fingers) beeinträchtigt die vorgeschlagene Berührungserkennung nicht die Arbeitsweise und Performance der übrigen Komponenten des Sensorelementes.

Dies gilt auch für die zweite Variante der Erfindung, die nach dem Prinzip der Pulsmodulation arbeitet.

Bei dieser sind die erste und die zweite Einrichtung mit einer Signalerzeugungseinrichtung verbunden, von der der ersten und der zweiten Einrichtung ein periodisches Signal konstanter Frequenz zugeführt wird.

Die zweite Einrichtung verfügt über ein Mittel zur Umwandlung der Kapazität des zweiten Ladungsspeichers in ein periodisches Signal der konstanten Frequenz mit variabler Pulsweite. Die Größe der Kapazität des zweiten Ladungsspeichers wird also gemäß dem Gedanken der Erfindung mit einer elektronischen Schaltung in ein periodisches Signal mit variabler Pulsweite umgewandelt. Dieses Signal hat eine konstante Frequenz und eine je nach Berührung oder Nicht-Berührung unterschiedliche Pulsbreite.

Die Berührungserkennung erfolgt dann durch analogen Pulsbreiten-Vergleich mit einem Signal gleicher Frequenz und konstanter, geeignet gewählter Pulsbreite (Referenzfrequenzsignal). Zu diesem Zweck ist es vorteilhaft, wenn die zweite Einrichtung einen Inverter aufweist, der das von der Signalerzeugungseinrichtung abgegebene Signal invertiert. Der Vergleich kann dann dadurch erfolgen, dass die Auswerte-Einrichtung gemäß einer vorteilhaften Ausgestaltung der Erfindung einen Ladungsspeicher aufweist, dem die überlagerten (addierten) Signale der ersten und der zweiten Einrichtung zugeführt werden.

Das Prinzip ist, daß das Referenzfrequenzsignal die erste und zweite Einrichtung ansteuert. In der zweiten Einrichtung wird es lediglich invertiert, d.h. die Pulsbreiten werden nicht verändert. Grund der Invertierung ist, daß der Ausgang dieser Einrichtung eine mit dem invertierten Signal gepulste Stromquelle (und dadurch Stromsenke) ist. Hierdurch werden Ladungspakete vom nachfolgenden Ladungsspeicher (der auch als (Integrations-)Kondensator bezeichnet wird) entnommen. In der ersten Einrichtung wird das Referenzfrequenzsignal nicht invertiert, aber die Pulsbreite ändert sich bei Berührung, wodurch die positiven Pulse folglich länger werden. Der Ausgang der ersten Einrichtung ist eine mit diesem Signal gepulste Stromquelle. Dadurch werden Ladungspakete auf den nachfolgenden Ladungsspeicher ((Integrations-)Kondensator) gegeben. In der Summe bewirken die beiden gepulsten Stromquellen (nach einer bestimmten Anzahl von Pulsperioden), daß der Ladungsspeicher auf ein Potential unterhalb der Schaltschwelle des nachfolgenden Inverters entladen wird, wenn keine Berührung stattfindet bzw. der Ladungspeicher auf ein Potential oberhalb der der Schaltschwelle des nachfolgenden Inverters aufgeladen wird, wenn eine Berührung stattfindet.

Auch die Variante der Pulsmodulation basiert auf einem einfachen, zuverlässigen Messprinzip, das unabhängig ist von den Messvorgängen, die zur Erfassung eines Fingerabdruckes des Sensorelementes verwendet werden. Gleichfalls wie die erste Variante kann das beschriebene Messprinzip separat entwickelt und optimiert werden, ohne die Eigenschaften des Sensorelementes zu beeinflussen.

### Kurze Beschreibung der Zeichnungen

Die Erfindung und deren Vorteile werden anhand zweier Ausführungsbeispiele weiter erläutert. Es zeigen:
- Figur 1: eine Anordnung zum Detektieren einer Berührung eines Sensorelementes, die nach dem Prinzip der Signallaufzeitveränderung arbeitet und
- Figur 2: eine Anordnung zum Detektieren einer Berührung eines Sensorelementes, die nach dem Prinzip der Pulsmodulation arbeitet.

### Wege zur Ausführung der Erfindung

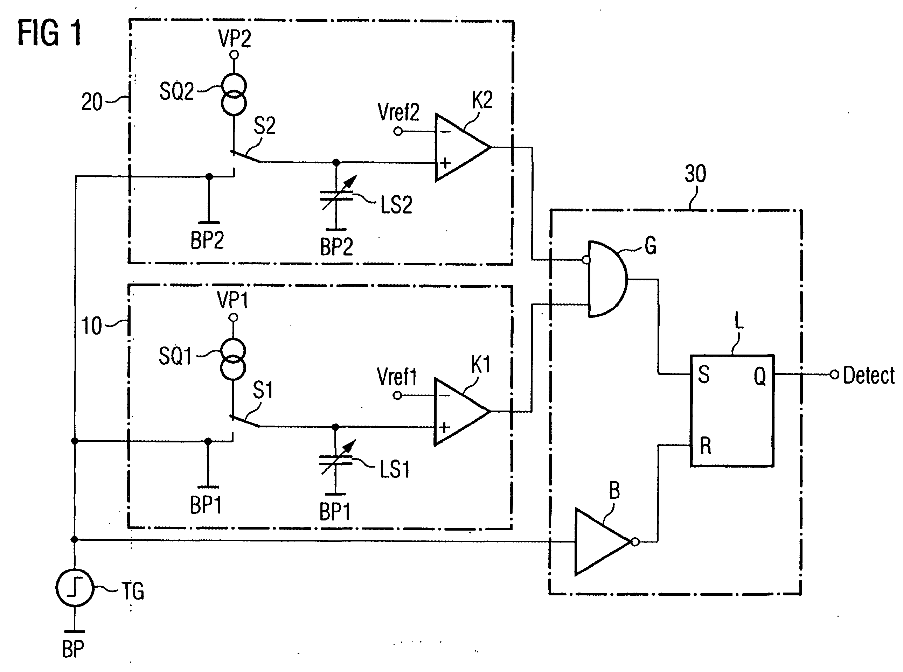

Figur 1 zeigt in einer schematischen Darstellung eine Anordnung zum Detektieren einer Berührung eines Sensorelementes, die nach dem Prinzip der Signallaufzeitveränderung arbeitet. Die Anordnung weist eine erste Einrichtung 10 auf, die ein von der Berührung unabhängiges erstes Signal erzeugt. Mit dem Bezugszeichen 20 ist eine zweite Einrichtung bezeichnet, die ein von der Berührung abhängiges zweites Signal erzeugt. Schließlich ist mit den Bezugszeichen 30 eine Auswerte-Einrichtung dargestellt, die bei einer Abweichung zwischen dem ersten und dem zweiten Signal ein weiteres Signal DETECT abgibt. Darüber hinaus ist ein Taktsignalgenerator TG vorgesehen, der ein Taktsignal jeweils der ersten Einrichtung 10, der zweiten Einrichtung 20 sowie der Auswerte-Einrichtung 30 zur Verfügung stellt.

Die zweite Einrichtung 20 weist einen Ladungsspeicher LS2 auf, der das Sensorelement repräsentiert. Dieses Sensorelement weist die Eigenschaft auf, dass es eine unterschiedliche elektrische Kapazität hat, abhängig davon, ob es von einem Finger oder einem Gegenstand berührt wird oder nicht. Der zweite Ladungsspeicher LS2 ist zwischen einem Bezugspotentialanschluss BP2 und dem nicht-invertierenden Eingang eines Komparators K2 verschalten. Der invertierende Eingang des Komparators K2 ist mit einer Referenzspannung Vref2 beaufschlagt. Der Knotenpunkt zwischen dem zweiten Ladungsspeicher LS2 und dem nicht-invertierenden Eingang des Komparators K2 ist über einen Schalter S2 einerseits mit einer Stromquelle SQ2 oder einem Bezugspotential BP2 verbindbar. Die Stromquelle SQ2 ist ihrerseits mit einem Versorgungspotential an einem Versorgungspotentialausschluß VP2 beaufschlagt. Die Schalterstellung des Schalters S2 wird durch den Taktsignalgenerator TG gesteuert. Der Ausgang des Komparators K2 stellt den Ausgang der zweiten Einrichtung 20 dar. Dieses Signal wird der Auswerte-Einrichtung 30 zur weiteren Verarbeitung zur Verfügung gestellt.

Der Aufbau der ersten Einrichtung 10 entspricht dem der zweiten Einrichtung 20. Die jeweiligen Bezugszeichen der ersten Einrichtung 10 sind deshalb entsprechend gewählt, wobei anstatt der "2" eine "1" auf ein Eelement dieser Einrichtung hinweist. Anstatt des zweiten Ladungsspeichers LS2, der eine variable Kapazität darstellt, ist der erste Ladungsspeicher LS1 jedoch konstant. Das Ausgangssignal des Komparators K1 wird der Auswerte-Einrichtung 30 zur weiteren Verarbeitung zur Verfügung gestellt.

Die Auswerte-Einrichtung 30 weist ein Gatter G auf, dessen Eingänge mit den Ausgangssignalen der Komparatoren K1, K2 beaufschlagt werden. Das von der zweiten Einrichtung 20 gelieferte Ausgangssignal wird hierbei invertiert. Ausgangsseitig ist das Gatter G mit dem Set-Eingang eines Latches L verbunden. Der Reset-Eingang des Latches L ist über einen Verstärker B an den Taktsignalgenerator TG angeschlossen. An dem Ausgang Q des Latches L läßt sich schließlich feststellen, ob an dem Sensorelement bzw. zweiten Ladungsspeicher LS2 ein Finger oder Gegenstand anliegt oder nicht.

Das Verhalten der Anordnung im Falle einer Nicht-Berührung des zweiten Ladungsspeichers LS2 ist wie folgt: Über den Taktsignalgenerator TG2 werden die Schalter S1, S2 gleichzeitig mit dem Stromquellen SQ1, SQ2 verbunden. Gleichzeitig findet ein Reset des Latch L statt. Die zunächst entladenen Ladungsspeicher LS1, LS2 werden über die Stromquellen SQ1, SQ2 aufgeladen. Die Referenzspannungen Vref1, Vref2 sowie die Größe der Ladungsspeicher LS1, LS2 ist derart gewählt, dass die Komparatoren K1, K2 zum gleichen Zeitpunkt ihr Ausgangssignal ändern. Dies bedeutet, die über dem Ladungsspeicher LS2 anliegende Spannung erreicht etwas früher oder maximal gleichzeitig den Wert Vref2 gegenüber als LS1 den Wert Vref1. Das Ausgangssignal des Latches L ändert sich in diesem Falle nicht. Die aufgeladenen Ladungsspeicher LS1, LS2 werden durch Verbinden der Schalter S1, S2 mit den Bezugspotentialen BP1, BP2 wieder entladen. Solange die Schalter S1, S2 mit den Bezugspotentialen BP1, BP2 verbunden sind, ändert sich auch das Ausgangssignal DETECT des Latches L nicht.

Sobald ein Finger oder ein anderer Gegenstand den zweiten Ladungsspeicher LS2 berührt, ändert dieser seine Kapazität. Die Zeitdauer, zu dem die über den zweiten Ladungsspeicher LS2 anliegende Spannung die Referenzspannung Vref2 erreicht, unterscheidet sich deshalb von der vorher gemessenen. Hingegen ändert sich die Zeitdauer zwischen dem Verbinden des ersten Ladungsspeichers LS1 mit der Stromquelle SQ1 und dem Kippen des Komparators K1 nicht. Am Ausgang des Gatters G findet nun zu einem Zeitpunkt, zu dem das Latch L aktiv ist, ein Signalwechsel statt, der schließlich über das Ausgangssignal DETECT am Ausgang Q angezeigt wird.

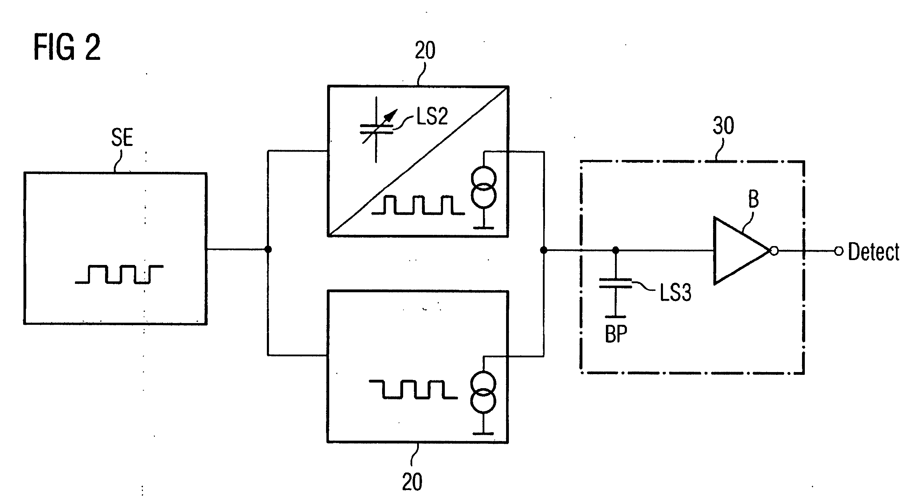

Figur 2 zeigt eine Anordnung zum Detektieren einer Berührung eines Sensorelementes, die nach dem Prinzip der Pulsmodulation arbeitet. Auch diese Anordnung umfaßt eine erste Einrichtung 10, die ein von der Berührung unabhängiges erstes Signal erzeugt. Wie im vorherigen Beispiel ist mit den Bezugszeichen 20 eine zweite Einrichtung bezeichnet, die ein von der Berührung abhängiges zweites Signal erzeugt. Darüber hinaus ist ebenfalls eine Auswerte-Einrichtung 30 vorgesehen, die bei Abweichung zwischen dem ersten und dem zweiten Signal ein weiteres Signal DETECT erzeugt. Die erste und die zweite Einrichtung 10, 20 sind jeweils mit einer Signalerzeugungseinrichtung SE verbunden, die diesen ein Signal konstanter Frequenz beaufschlagt. Im vorliegenden Ausführungsbeispiel umfaßt die erste Einrichtung 10 lediglich einen Inverter, der das von der Signalerzeugungseinrichtung SE erzeugte Signal invertiert.

Die zweite Einrichtung 20 umfaßt wiederum den zweiten Ladungsspeicher, der das Sensorelement repräsentiert. Abhängig von der Größe der Kapazität, die davon abhängt, ob das Sensorelement von einem Finger oder Gegenstand berührt wird oder nicht, beeinflusst diese das von der Signalerzeugungseinrichtung SE abgegebene Signal hinsichtlich seiner Pulsweite. Die Frequenz hingegen bleibt unbeeinflußt. Das solchermaßen varierte Signal wird mit dem invertierten Signal aus der ersten Einrichtung 10 überlagert und der Auswerte-Einrichtung 30 zugeführt.

Die Auswerte-Einrichtung 30 umfaßt einen Ladungsspeicher LS3, der einerseits mit den Ausgängen der ersten und zweiten Einrichtung 10, 20 und andererseits mit einem Bezugspotential BP3 verbunden ist. Der Ladungsspeicher LS3 ist darüber hinaus über einen Verstärker B mit dem Ausgang der Anordnung verbunden.

Das Prinzip ist, daß das Referenzfrequenzsignal die erste und zweite Einrichtung 10, 20 ansteuert. In der zweiten Einrichtung 20 wird es lediglich invertiert, d.h. die Pulsbreiten werden nicht verändert. Grund der Invertierung ist, daß der Ausgang dieser Einrichtung eine mit dem invertierten Signal gepulste Stromquelle (und dadurch Stromsenke) ist. Diese ist in der Figur lediglich schematisch eingezeichtnet. Hierdurch werden Ladungspakete vom nachfolgenden Ladungsspeicher LS3 (der auch als (Integrations-)Kondensator bezeichnet wird) entnommen. In der ersten Einrichtung 10 wird das Referenzfrequenzsignal nicht invertiert, aber die Pulsbreite ändert sich bei Berührung, wodurch die positiven Pulse folglich länger werden. Der Ausgang der ersten Einrichtung ist eine mit diesem Signal gepulste Stromquelle. Auch diese ist lediglich schematisch dargestellt. Dadurch werden Ladungspakete auf den nachfolgenden Ladungsspeicher LS 3 gegeben. In der Summe bewirken die beiden gepulsten Stromquellen (nach einer bestimmten Anzahl von Pulsperioden), daß der Ladungsspeicher LS3 auf ein Potential unterhalb der Schaltschwelle des nachfolgenden Inverters B entladen wird, wenn keine Berührung stattfindet bzw. der Ladungspeicher auf ein Potential oberhalb der der Schaltschwelle des Inverters B aufgeladen wird, wenn eine Berührung stattfindet.

Die Erfindung schafft eine von der Schaltungsanordnung des Sensorelementes unabhängige Schaltung zur Berührungserkennung, die dazu eine Relativmessung durch Kombination eines bei kapazitiven Sensoren vorhandenen Sensorelements und eines Referenzelements nutzt. Die Erfindung weist den Vorteil auf, dass sie gegenüber herkömmlichen Anordnungen weniger Strom benötigt. Weiterhin vorteilhaft ist, dass die Berührungserkennung autonom von den übrigen Schaltungsbestandteilen des Sensorelementes ist. Insbesondere kann diese eingesetzt werden, auch wenn die übrigen Schaltungselemente des Sensorelementes (zur Erkennung des biometrischen Fingerabdruckes) abgeschaltet sind. Im Falle des regulären Betriebs des Sensorelementes beeinträchtigt die Berührungserkennung nicht die Arbeitsweise und Performance der Schaltungselemente des Sensorelements.

### Bezugszeichenliste

- 10: erste Einrichtung
- 20: zweite Einrichtung
- 30: Auswerte-Einrichtung
- VP: Versorgungspotential
- BP: Bezugspotential
- TS: Taktsignalgenerator
- VP1: Versorgungspotential
- BP1: Bezugspotential
- SQ1: Stromquelle
- S1: Schalter
- LS1: Ladungsspeicher
- K1: Komparator
- Vref1: Referenzspannung
- VP2: Versorgungspotential
- BP2: Bezugspotential
- SQ2: Stromquelle
- S2: Schalter
- LS2: Ladungsspeicher
- K2: Komparator
- Vref2: Referenzspannung
- G: Gatter
- B: Verstärker
- L: Latch
- SE: Signalerzeugungseinrichtung
- DETECT: Signal

## Patentansprüche

1. Anordnung zum Detektieren einer Berührung eines Sensorelementes mit einer ersten Einrichtung (10), die ein von der Berührung unabhängiges erstes Signal erzeugt, und mit einer zweiten Einrichtung (20), die ein von der Berührung abhängiges zweites Signal erzeugt, sowie mit einer Auswerte-Einrichtung (30), die bei Abweichung zwischen dem ersten und dem zweiten Signal ein weiteres Signal (DETECT) abgibt.

2. Anordnung nach Anspruch 1,
**dadurch gekennzeichnet, daß** eine Abweichung im Falle einer Berührung des Sensorelements gegeben ist.

3. Anordnung nach Anspruch 1 oder 2,
**dadurch gekennzeichnet, daß** die zweite Einrichtung (20) einen zweiten Ladungsspeicher (LS2), dessen Kapazität mit einer Berührung veränderbar ist, umfasst.

4. Anordnung nach einem der Ansprüche 1 bis 3,
**dadurch gekennzeichnet, daß** die erste und die zweite Einrichtung (10, 20) nach dem Prinzip der Signallaufzeitveränderung arbeiten.

5. Anordnung nach Anspruch 4,
**dadurch gekennzeichnet, daß** die erste Einrichtung (10) einen ersten Ladungsspeicher (LS1) aufweist, dessen Kapazität konstant ist.

6. Anordnung nach Anspruch 4 oder 5,
**dadurch gekennzeichnet, daß** die erste und die zweite Einrichtung (10, 20) jeweils einen Komparator (K1, K2) aufweisen, der die an dem ersten und dem zweiten Ladungsspeicher (LS1, LS2) anliegende Spannung jeweils mit einer Referenzspannung (Vref1, Vref2) vergleicht.

7. Anordnung nach Anspruch 6,
**dadurch gekennzeichnet, daß** der Auswerte-Einrichtung (30) die von den Komparatoren (K1, K2) erzeugten Ausgangssignale für die weitere Auswertung zugeführt sind.

8. Anordnung nach einem der Ansprüche 4 bis 7,
**dadurch gekennzeichnet, daß** die erste und die zweite Einrichtung (10, 20) jeweils eine Stromquelle (SQ1, SQ2) und einen zwischen der Stromquelle (SQ1, SQ2) und dem jeweiligen Ladungsspeicher (LS1, LS2) gelegenen Schalter (S1, S2) aufweisen, wobei die Schalter (S1, S2) in Abhängigkeit eines Taktsignalgenerators (TS) den jeweiligen Ladungsspeicher mit der Stromquelle (SQ1, SQ2) oder einem Bezugspotential verbinden.

9. Anordnung nach einem der Ansprüche 1 bis 3,
**dadurch gekennzeichnet, daß** die erste und die zweite Einrichtung (10, 20) nach dem Prinzip der Pulsmodulation arbeiten.

10. Anordnung nach Anspruch 9,
**dadurch gekennzeichnet, daß** die erste und die zweite Einrichtung (10, 20) mit einer Signalerzeugungseinrichtung (SE) verbunden sind, von der diesen ein periodisches Signal konstanter Frequenz zugeführt wird.

11. Anordnung nach Anspruch 9 oder 10,
**dadurch gekennzeichnet, daß** die zweite Einrichtung (20) über ein Mittel zur Umwandlung der Kapazität des zweiten Ladungsspeichers (20) in ein periodisches Signal der konstanten Frequenz mit variabler Pulsweite verfügt.

12. Anordnung nach einem der Ansprüche 9 bis 11,
**dadurch gekennzeichnet, daß** der ersten oder der zweiten Einrichtung (10, 20) ein Inverter vorgeschalten ist, der das von der Signalerzeugungseinrichtung (SE) abgegebene Signal invertiert.

13. Anordnung nach einem der Ansprüche 9 bis 12,
**dadurch gekennzeichnet, daß** die Auswerteeinrichtung (30) einen Ladungsspeicher (LS3) aufweist, dem die überlagerten Signale der ersten und zweiten Einrichtung (10, 20) zugeführt werden.

14. Anordnung nach einem der Ansprüche 1 bis 13,
**dadurch gekennzeichnet, daß** das Sensorelement der zweite Ladungsspeicher (LS2) ist.

15. Verfahren zum Detektieren einer Berührung eines Sensorelementes, bei dem bei der Berührung des Sensorelementes aufgrund einer sich ändernden Kapazität des Sensorelementes eine Änderung der Laufzeit eines Signales herbeigeführt wird, und anschließend ein Vergleich der veränderten Laufzeit mit der Laufzeit eines Referenzsignales vorgenommen wird.

16. Verfahren zum Detektieren einer Berührung eines Sensorelementes, bei dem bei der Berührung des Sensorelementes aufgrund einer sich ändernden Kapazität des Sensorelementes eine Änderung der Pulsbreite eines Signals mit konstanter Frequenz herbeigeführt wird, und anschließend ein Pulsbreitenvergleich mit einem Referenzsignal gleicher Frequenz vorgenommen wird.
